# EUROPEAN PATENT APPLICATION

(11) **EP 0 822 274 A2**
(43) Date of publication of application: **04.02.1998**
(21) Application number: 97305458.8
(22) Date of filing: 22.07.1997
(51) Int. Cl.: C30B 25/02, C30B 29/06

(54) **Method for manufacturing epitaxial wafer**

(30) Priority: 30.07.1996 JP 200689/96
(71) Applicant: Shin-Etsu Handotai Company, Limited, Chiyoda-ku Tokyo 100 (JP)
(72) Inventor: Ose, Hiroki, C/o Isobe Factory, Annaka-shi, Gunma (JP)
(74) Representative: Rackham, Stephen Neil

(57) **Abstract**

A method for manufacturing an epitaxial wafer. The method comprises the steps of loading a first silicon single crystal (1,11) in a reaction chamber (56) and growing a protection layer (4,14) of silicon single crystal in vapor phase on the first silicon single crystal (1,11). The inside of the reaction chamber (56) containing the first silicon single crystal (1,11) having the grown protection layer (4,14) of silicon single crystal is then dry-etched and purged subsequently before growing a desired silicon single crystal layer (5,15) in vapor phase.

## Description

The present invention relates to a method for manufacturing an epitaxial wafer, and especially to a method for growing a silicon single crystal layer in vapor phase on a silicon crystal substrate or the like which is placed in a reaction chamber.

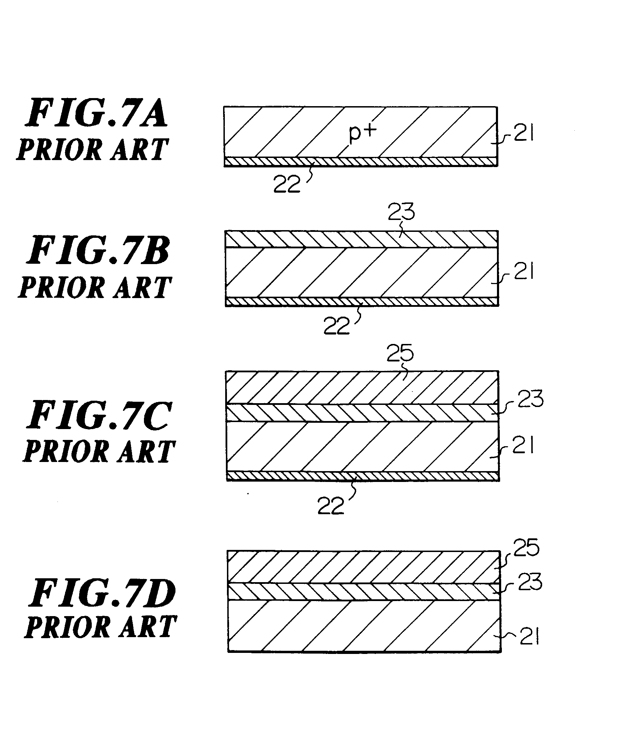

An Insulated Gate Bipolar Transistor (hereinafter, which may be called "IGBT") is a composite element of a bipolar transistor and a power MOSFET, which is made up in a chip monolithically. A silicon wafer for IGBT which is used for fabricating the IGBTs is generally manufactured by the steps shown in FIGS. 7A-7D.

In the manufacturingmethod, for example, as a first layer, an n⁺ silicon single crystal layer 23 having a relatively low resistivity of about 0.08 Ω·cm is grown in vapor phase on the main surface of a p⁺ silicon single crystal substrate 21 shown in FIG. 7A, having a low resistivity of not more than 0.02 Ω·cm, as shown in FIG. 7B. On the rear surface of the silicon single crystal substrate 21, a CVD oxide film 22 of silicon oxide is formed to prevent autodoping caused by the evaporation of dopants from the rear surface. Then, as a second layer, an n⁻ silicon single crystal layer 25 having a relatively high resistivity of about 80 Ω·cm is grown in vapor phase on the silicon single crystal layer 23, as shown in FIG. 7C, and thereafter, the CVD oxide film 22 is removed, as shown in FIG. 7D. Thus, a silicon wafer for IGBT is manufactured.

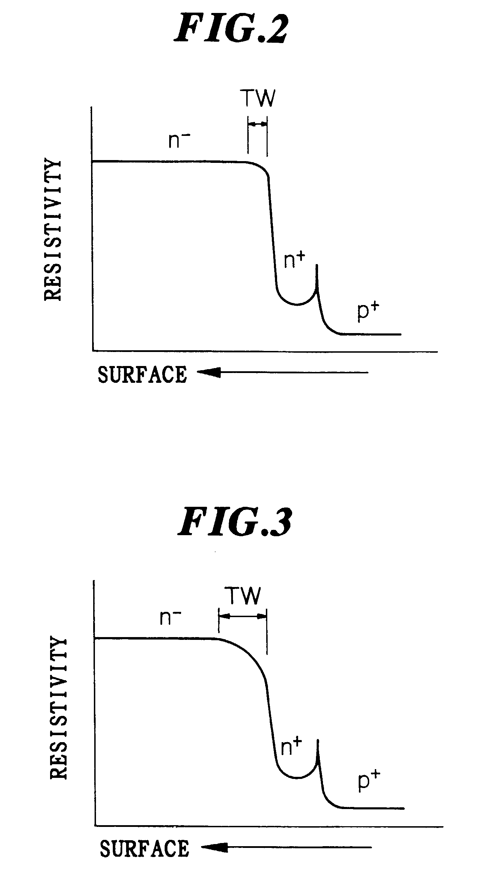

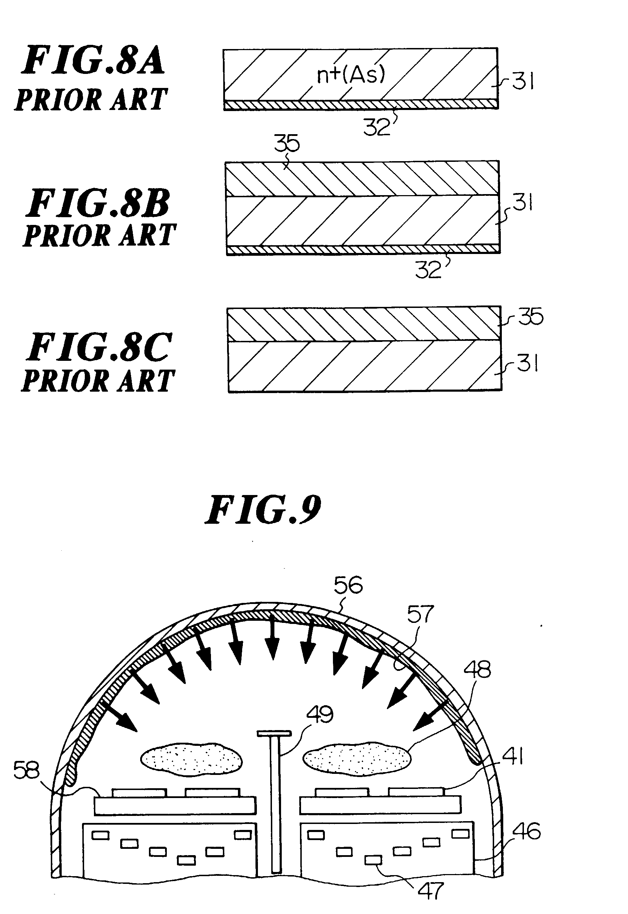

In the conventional method, the step of growing the first layer 23 of silicon single crystal in vapor phase, which is shown in FIG. 7B, and the step of growing the second layer 25 of silicon single crystal in vapor phase, which is shown in FIG. 7C, are performed by using separate reaction chambers to each other. The reason of this is that although a silicon wafer for IGBT requires a large difference between the resistivity ρ1 of the first layer (n⁺) and the resistivity ρ2 of the second layer (n⁻), e.g., of the degree to which ρ1:ρ2=1:1000, if the first layer and the second layer are grown in the same reaction chamber successively, dopants used for growing the first layer exerts adverse effect on growth of the second layer by the so-called memory effect, and consequently, the width TW of the transition region (hereinafter, which may be called "transition width") in the interface between the first layer and the second layer becomes broader, as shown in the resistivity profile of FIG. 3. The "memory effect" means a phenomenon in which dopants which were adhered on the inner wall of a reaction chamber 56, the surface of a susceptor 58, a gas nozzle 49, a coil cover 46 for covering a high-frequency heating coil 47, and other parts in the reaction chamber during the previous growing step, separate therefrom and are trapped within the epitaxial growth layer, as shown in FIG. 9. In this Figure, the reference numeral 57 denotes dopants adhered on the inner wall of the reaction chamber 56, and the reference numeral 48 denotes a dopant atmosphere with a high concentration.

In a conventional method for growing a silicon single crystal layer in vapor phase on a silicon single crystal substrate having a low resistivity of not more than 0.02 Ω·cm by heavily doping of volatile dopants, like an arsenic (As)-doped substrate, for example, on the main surface of an As-doped n⁺ silicon single crystal substrate 31 having a CVD oxide film 32 for preventing autodoping on the rear surface, which is shown in FIG. 8A, a desired silicon single crystal layer 35 is grown in vapor phase, as shown in FIG. 8B, and thereafter the CVD oxide film 32 is removed, as shown in FIG. 8C.

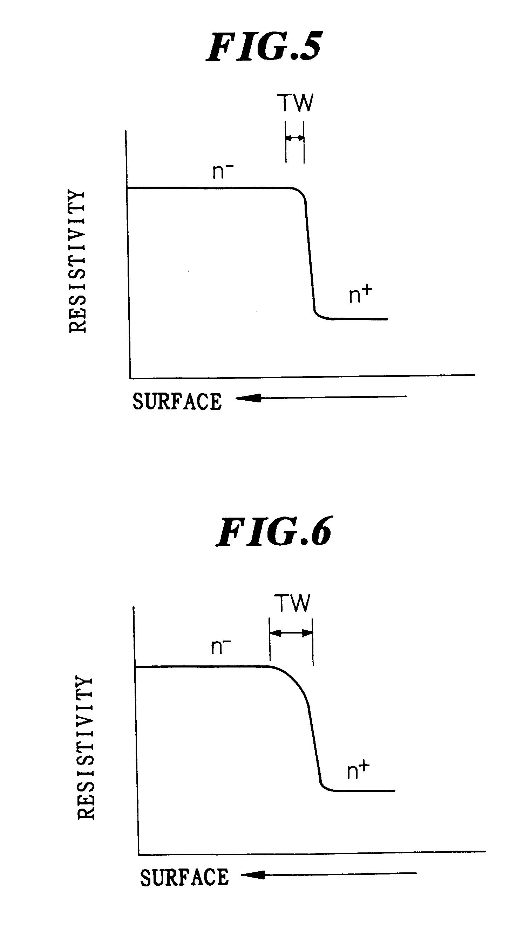

In such a case, dry etching for the inside of the reaction chamber by using HCl gas is required after every vapor phase growth. The reason of this is that when a plurality of vapor phase growth are successively repeated, dopants which were evaporated from the substrate are accumulated on the inner wall of the reaction chamber and the like, so that they exert adverse effect on vapor phase growth of a silicon single crystal layer by mainly the memory effect, and consequently, the transition width TW in the interface between the substrate and the epitaxial layer becomes also broader, as shown in the resistivity profile of FIG. 6.

However, in a method for manufacturing a silicon wafer for IGBT, when the step shown in FIG. 7B and the step shown in FIG. 7C are carried out by using separate reaction chambers to each other, additional steps, e.g., cooling, unloading, cleaning, loading, and rising in temperature, are required, in comparison with the case of carrying out both steps in the same reaction chamber successively. Consequently, there are problems of low productivity and increase in production cost for a silicon wafer for IGBT.

In the case of growing a silicon single crystal layer in vapor phase on a silicon single crystal substrate into which volatile dopants were heavily doped, like an As-doped substrate, because a dry etching for the inside of the reaction chamber by using HCl gas is required after every vapor phase growth, there is also a problem of low productivity.

According to the present invention, a method for manufacturing an epitaxial wafer comprises the steps of: loading a first silicon single crystal in a reaction chamber; growing a protection layer of silicon single crystal in vapor phase on the first silicon single crystal; dry-etching an inside of the reaction chamber while containing the first silicon single crystal having the grown protection layer of silicon single crystal in the reaction chamber; purging the dry-etched atmosphere of the reaction chamber; and thereafter growing a desired silicon single crystal layer in vapor phase.

According to the manufacturing method, because a desired epitaxial silicon single crystal layer is grown in vapor phase after the inside of the reaction chamber was dry-etched, it is possible to effectively suppress the so-called memory effect and to make the transition width in the resistivity profile narrow. Further, because a protection layer is grown in vapor phase on the first silicon single crystal before dry-etching, the first silicon single crystal is not etched off by virtue of the protection layer formed thereon, so that it is possible to prevent evaporation of dopants from the first silicon single crystal into the reactive atmosphere during dry etching. After dry etching, because etching gas is discharged out of the reaction chamber by purging the atmosphere of the reaction chamber, the etching can be completely stopped before a desired epitaxial silicon single crystal layer is grown in vapor phase.

Preferably, the grown protection layer has a thickness enough to be remained after the dry-etching. In such a method, because the first silicon single crystal is not exposed by virtue of the remaining protection layer during the dry-etching although the protection layer is etched instead, an autodoping phenomenon in which dopants in the first silicon single crystal are evaporated into the reactive atmosphere to form a dopant atmosphere with a high concentration during the dry etching and the dopants are trapped within the growing epitaxial layer again, is effectivelyprevented. Further, becausethe protection layer remains also after the dry etching, the autodoping is prevented by the protection layer.

The remaining thickness of the protection layer after the dry-etching is preferably not less than 0.5 µm and not more than 5 µm and is more preferably not less than 1 µm and preferably not more than 3µm. If the remaining thickness of the protection layer after the dry-etching is too small, there is the possibility that autodoping might not be prevented sufficiently. This is especially the case for thicknesses less than 1 µm. On the other hand, if the remaining thickness of the protection layer is too great, this might exert adverse effect on the figure of the resistivity profile to lead to degradation of the characteristics of the epitaxial wafer.

Preferably, the step of growing the protection layer is carried out with no supply of a dopant gas. According to such a method, because the protection layer comprises a practically non-doped silicon single crystal, substantially no dopants are discharged to the atmosphere of the reaction chamber while the protection layer is etched, so that both autodoping and memory effect can be suppressed.

The step of dry-etching the inside of the reaction chamber may be carried out by using HCl gas. Accordingly, it is possible to effectively remove dopants which adhere to the inner wall of the reaction chamber and the like by using HCl gas for the dry-etching.

Preferably, an autodoping preventing film is formed on a rear surface of the silicon single crystal substrate prior to the growing step of the protection layer of silicon single crystal. Accordingly, it is possible to prevent autodoping from the rear surface of the first silicon single crystal. The purging step of the reaction chamber may be carried out by using H₂ gas.

Preferably the silicon single crystal substrate is an As-doped substrate having a low resistivity.

Preferably silicon single crystal substrate is doped with p-type impurities and has a low resistivity. In this case, an n-type silicon single crystal layer having a relatively low resistivity is grown in vapour phase on the p-type silicon single crystal substrate before growing the protection thin layer of silicon single crystal, and the layer grown on the dry-etched protection thin layer is an n-type silicon single crystal layer.

In the manufacturing method, because between the first and the third vapor phase growing steps, for growing n-type silicon single crystal layers having a relatively low resistivity and a relatively high resistivity, respectively, in vapor phase, a second vapor phase growing step for growing a protection layer of silicon single crystal, a dry-etching step for dry-etching an inside of the reaction chamber, and a purge step for purging the dry-etched atmosphere of the reaction chamber are performed, it is possible to effectively suppress the memory effect, that is, dopants used for growing the first n-type silicon single crystal layer having a relatively low resistivity exert adverse effect on growth of the third n-type silicon single crystal layer having a relatively high resistivity.

Preferably, purging are also carried out after the step of loading and before the first vapor phase growing step, and after the first vapor phase growing step and before the second vapor phase growing step.

The present invention will become more fully understood from the detailed description given hereinbelow and the accompanying drawings which are given by way of illustration only, and thus are not intended as a definition of the limits of the present invention, and wherein;
FIGS. 1A to 1F are vertical sectional views for showing steps for manufacturing a silicon wafer for IGBT of a first embodiment of the present invention;
FIG. 2 is a view showing the resistivity profile of the silicon wafer for IGBT according to the first embodiment;
FIG. 3 is a view showing the resistivity profile of the silicon wafer when no growth of the protection layer and no HCl gas etching are carried out in the first embodiment;
FIGS. 4A to 4E are vertical sectional views for showing steps for growing an epitaxial layer on an As-doped silicon single crystal substrate of a second embodiment of the present invention;
FIG. 5 is a view showing the resistivity profile of the silicon epitaxial wafer according to the second embodiment;
FIG. 6 is a view showing the resistivity profile of the silicon epitaxial wafer when no growth of the protection layer and no HCl gas etching are carried out in the second embodiment;
FIGS. 7A to 7D are vertical sectional views for showing steps for manufacturing a silicon wafer for IGBT according to a conventional method;
FIGS. 8A to 8C are vertical sectional views for showing steps for growing an epitaxial layer on an As-doped silicon single crystal substrate according to a conventional method; and
FIG. 9 is a schematic sectional view for explaining the memory effect in the reaction chamber.

### First Embodiment:

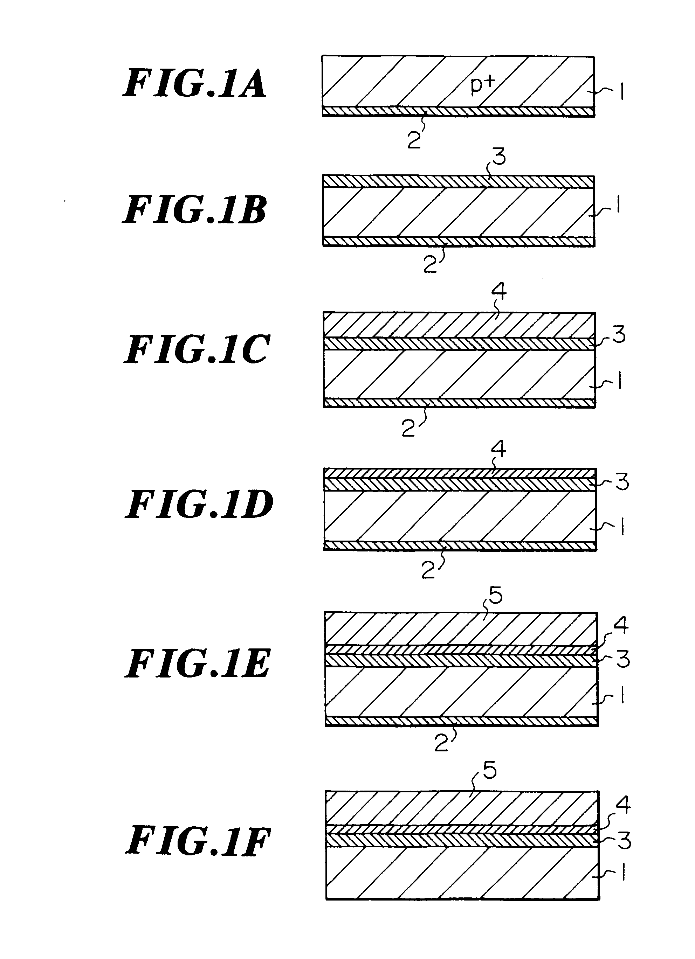

FIGS. 1A to 1F show steps in the method for manufacturing an epitaxial wafer according to the first embodiment of the present invention, in particular, for manufacturing an epitaxial silicon wafer for IGBT.

First, a plurality of p⁺ silicon single crystal substrates 1 having a low resistivity which is shown in FIG. 1A, are loaded in a reaction chamber 56 of a vertical furnace, as shown in FIG. 9. Each p⁺ silicon single crystal substrate 1 has a diameter of about 125 mm and the resistivity thereof is adjusted to 0.015 Ω·cm by heavily doping boron (B). On the rear surface of the p⁺ silicon single crystal substrate 1, a CVD oxide layer 2 is formed as an autodoping preventing film to prevent autodoping caused by the evaporation of dopants from the rear surface. As such an autodoping preventing film, not only silicon oxide but also silicon nitride or the like can be used.

After the inside of the reaction chamber 56 is purged with N₂ gas and with H₂ gas in order, the temperature thereof is raised up to 1150 °C and an n⁺ silicon single crystal layer 3 having a relatively low resistivity of about 0.08 Ω·cm and a thickness of 10 µm is grown in vapor phase on the main surface having a crystal orientation (100) of the silicon single crystal substrate 1, as shown in FIG. 1B.

Next, the inside of the reaction chamber 56 is purged with H₂ gas, and a non-doped silicon single crystal layer having a thickness of 10 µm is grown in vapor phase as a protection layer 4 on the n⁺ silicon single crystal layer 3, with no supply of the dopant gas, as shown in FIG. 1C.

Thereafter, the inside of the reaction chamber 56 is dry-etched by using HCl gas while containing the p⁺ silicon single crystal substrate 1 having the grown n⁺ silicon single crystal layer 3 and the grown protection layer 4, in the reaction chamber 56. During the dry-etching, the grown protection layer 4 is etched off at an etching rate of about 1 µm/min by HCl gas to cause a thickness reduction of about 7 µm. Therefore, the remaining thickness of the protection layer 4 is about 3 µm. This state is shown in FIG. 1D.

Next, the inside of the reaction chamber 56 is purged again with H₂ gas to discharge the HCl gas out of the reaction chamber 56, and thereafter, an n⁻ silicon single crystal layer 5 having a thickness of 100 µm and a relatively high resistivity of about 80 Ω·cm, which is a second silicon single crystal layer, is grown in vapor phase on the protection layer 4, as shown in FIG. 1E. After the vapor phase growth is finished, the temperature of the inside of the reaction chamber 56 is lowered and after the silicon single crystal substrates 1 having the grown epitaxial layers thereon are unloaded from the reaction chamber 56, the CVD oxide film 2 is removed by using dilute hydrofluoric acid, as shown in FIG. 1F.

The resistivity profile of the silicon epitaxial wafer for IGBT which has been completed by the above process is shown in FIG. 2. The resistivity profile of the silicon epitaxial wafer when the two n-type silicon single crystal layers 3 and 5 have been grown in vapor phase with no growth of the protection layer 4 and no HCl gas etching, is shown in FIG. 3, as a comparative example.

The transition width TW in the interface between the first n⁺ layer and the second n⁻ layer shown in FIG. 2 is 12 µm. The transition width TW is sufficiently narrow in comparison with that of FIG. 3 which is 60 µm, and the transition region has a steep figure. This fact shows that dopants adhering on the inner wall of the reaction chamber 56 and the like could be sufficiently removed to prevent occurrence of the memory effect effectively. The thickness of the protection layer 4 of silicon single crystal to be remained after dry-etching is preferably 1-5 µm because an excess thickness of the protection layer exerts adverse effect on the figure of the resistivity profile.

### Second Embodiment:

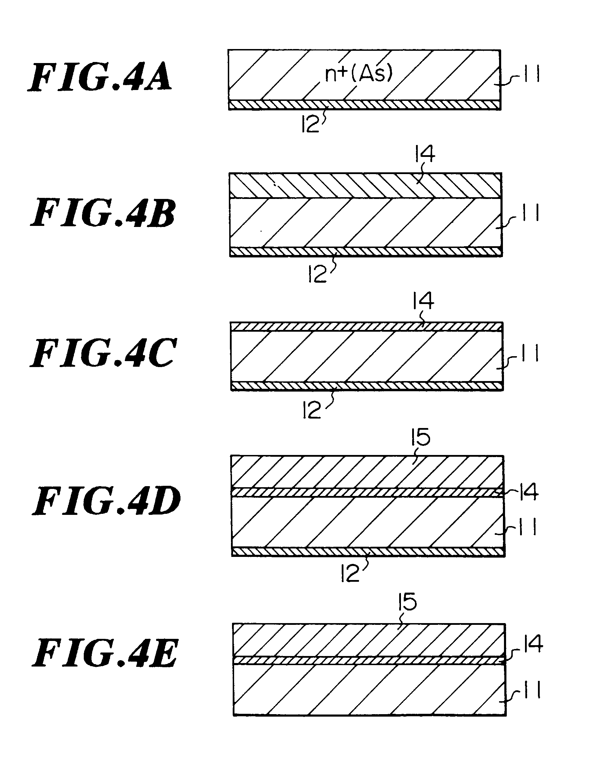

FIGS. 4A to 4E are vertical sectional views for showing steps in the method for manufacturing an epitaxial wafer according to the second embodiment of the present invention, in particular, for growing an epitaxial silicon layer on an As (Arsenic)-doped silicon single crystal substrate 11.

First, a plurality of As-doped n⁺ silicon single crystal substrates 11 shown in FIG. 4A, each of which has a CVD oxide film 12 of silicon oxide on the rear surface to prevent autodoping from the rear surface, are loaded in a reaction chamber 56 of a vertical furnace, as shown in FIG. 9. The resistivity of the n⁺ silicon single crystal substrates 11 is adjusted to 0.003 Ω·cm by doping As heavily. After the inside of the reaction chamber 56 is purged with N₂ gas and with H₂ gas in order, the temperature thereof is raised up to 1150 °C and a non-doped silicon single crystal layer having a thickness of about 5 µm is grown in vapor phase as a protection layer 14, on the main surface having a crystal orientation (111) of the As-doped n⁺ silicon single crystal substrate 11, with no supply of the dopant gas, as shown in FIG. 4B. Next, the inside of the reaction chamber 56 is dry-etched while containing the As-doped n⁺ silicon single crystal substrate 11 having the grown protection layer 14 in the reaction chamber 56. During the dry-etching, the grown protection layer 14 is etched off at an etching rate of about 1 µm/min by HCl gas to cause a thickness reduction of about 4 µm. Therefore, the remaining thickness of the protection layer 14 is about 1 µm. The thickness of the protection layer 14 of silicon single crystal to be remained after dry-etching is preferably 0.5-3 µm. The state of the etched-off As-doped n⁺ silicon single crystal substrate 11 is shown in FIG. 4C.

Next, the inside of the reaction chamber 56 is purged with H₂ gas, and thereafter, an n⁻ silicon single crystal layer 15 having a thickness of about 12 µm and a resistivity of about 5 Ω·cm, is grown in vapor phase on the protection layer 14, as shown in FIG. 4D. After the vapor phase growth is finished, the temperature of the inside of the reaction chamber 56 is lowered and after the As-doped n⁺ silicon single crystal substrate 11 having the grown epitaxial layers thereon are unloaded from of the reaction chamber 56, the CVD oxide film 12 is removed by using dilute hydrofluoric acid, as shown in FIG. 4E.

The resistivity profile of the silicon epitaxial wafer which has been completed by the above process is shown in FIG. 5. The resistivity profile of the silicon epitaxial wafer when the n-type silicon single crystal layer 15 has been grown in vapor phase on the As-doped n⁺ silicon single crystal substrate 11 having a low resistivity, with no growth of the protection layer 14 and no HCl gas etching, is shown in FIG. 6, as a comparative example.

The transition width TW in the interface between the substrate and the epitaxial layer, shown in FIG. 5 is about 1 µm. The transition width TW is sufficiently narrow in comparison with that of FIG. 6 which is about 3 µm, and the transition region has a steep figure. This fact shows that autodoping from the As-doped n⁺ silicon single crystal substrate 11 could be effectively suppressed and dopants adhering on the inner wall of the reaction chamber 56 and the like could be sufficiently removed to prevent occurrence of the memory effect effectively.

In the embodiment, formation of the protection layer and dry etching thereto are carried out once respectively. However, it is preferable to carry out the combination of formation of the protection layer and dry etching thereto several times when a formation of the protection layer and a dry etching thereto could not suppress the memory effect sufficiently.

As described above, the method according to the invention gives the autodoping suppression due to formation of a non-doped silicon single crystal layer prior to formation of a desired silicon single crystal layer, and the memory effect suppression due to dry-etching the dopants accumulated in the reaction chamber by using HCl gas, by one epitaxial production step. One epitaxial production step is from loading wafers to unloading wafers. Therefore, in the case of manufacturing an epitaxial wafer for IGBT which have an epitaxial silicon single crystal layer of a low resistivity and an epitaxial silicon single crystal layer of a high resistivity, the low resistivity layer and the high resistivity layer can be grown continuously during one epitaxial production step. In the case of growing an epitaxial layer on an As-doped silicon single crystal substrate, dry-etching the inside of the reaction chamber after every batch is not required and therefore it is possible to improve the productivity and to reduce the production costs. Further, it is also possible to obtain a resistivity profile having a transition region of a steep and stable figure.

## Claims

1. A method of manufacturing an epitaxial wafer comprising the steps of:
loading a first silicon single crystal (1,11) in a reaction chamber (56);
growing a protection layer (4,14) of silicon single crystal in vapor phase on the first silicon single crystal (1,11) ;
dry-etching an inside of the reaction chamber (56) while containing the first silicon single crystal (1,11) having the grown protection layer (4,14) of silicon single crystal in the reaction chamber (56);
purging the dry-etched atmosphere of the reaction chamber (56); and thereafter
growing a desired silicon single crystal layer (5,15) in vapor phase on the protection layer (4,14).

2. A method of manufacturing an epitaxial wafer as claimed in claim 1, wherein the grown protection layer (4,14) has a thickness sufficient for the layer to remain after the dry-etching.

3. A method of manufacturing an epitaxial wafer as claimed in claim 2, wherein the remaining thickness of the protection layer (4,14) after the dry-etching is not less than 1 µm and not more than 5 µm.

4. A method of manufacturing an epitaxial wafer as claimed in claim 2, wherein the remaining thickness of the protection layer (4,14) after the dry-etching is not less than 0.5 µm and not more than 3 µm.

5. A method for manufacturing an epitaxial wafer as claimed in any one of the preceding claims, wherein the step of growing the protection layer (4,14) in vapor phase is carried out with no supply of a dopant gas.

6. A method for manufacturing an epitaxial wafer as claimed in any one of the preceding claims, wherein the step of dry-etching the inside of the reaction chamber (56) is carried out by using HCl gas.

7. A method for manufacturing an epitaxial wafer as claimed in any one of the preceding claims, wherein an autodoping preventing film (2) is formed on a rear surface of the first silicon single crystal (1) prior to the growing step of the protection layer (4) of silicon single crystal to prevent autodoping from the rear surface of the first silicon single crystal (1).

8. A method for manufacturing an epitaxial wafer as claimed in any one of the preceding claims, wherein the purging step of the reaction chamber (56) is carried out by using H₂ gas.

9. A method for manufacturing an epitaxial wafer as claimed in any one of the preceding claims, wherein purging are also carried out after the step of loading and before the first vapor phase growing step, and after the first vapor phase growing step and before the second vapor growing step.

10. A method according to any one of the preceding claims, in which the silicon single crystal substrate (1,11) is an As-doped substrate having low resistivity.

11. A method according to any one of claims 1 to 9, in which the silicon single crystal substrate (1,11) is doped with a p-type impurity, and in which an n-type silicon single crystal layer (3) is formed by vapor phase growth before the protection layer (4,14), the protection layer (4,14) if formed on the n-type silicon single crystal layer (3), and in which the layer (5) grown on the dry-etched protection layer (4,14) is an n-type layer (5).
